# EUROPÄISCHE PATENTSCHRIFT

(11) **EP 0 314 895 B1**
(45) Veröffentlichungstag und Bekanntmachung des Hinweises auf die Patenterteilung: **11.08.1993**
(21) Anmeldenummer: 88114459.6
(22) Anmeldetag: 05.09.1988
(51) Int. Cl.: H01H 85/143, H01H 85/04, H01H 69/02

(54) **Sicherungselement**
Fuse element
Element fusible

(30) Priorität: 03.11.1987 CH 4289/87
(43) Veröffentlichungstag der Anmeldung: 10.05.1989
(73) Patentinhaber: Schurter AG, CH-6005 Luzern (CH)
(72) Erfinder: Rohrer, Heinrich, CH-6072 Sachseln (CH); Staubli, Werner, CH-6010 Kriens (CH)
(74) Vertreter: Kemény, Andreas

(56) Entgegenhaltungen:
- EP-A- 0 270 954
- CH-A- 566 641
- US-A- 4 689 597
- US-A- 4 755 785

## Beschreibung

Die Erfindung betrifft ein Sicherungselement nach dem Oberbegriff des Anspruchs 1.

Sicherungselemente dieser Art, welche vorwiegend als Sicherungseinsätze, die auch Schmelzeinsätze genannt werden, bekannt sind, sind in vielerlei Ausführungen bekannt vgl. GB-A-824 827. Sie haben manchmal sogar recht kleine Abmessungen, eignen sich aber nicht praktisch für die Verwendung als SMD-Sicherungselemente. Bei dem Sicherungselement gemäss GB-A-824 827 sind die Endkontakte Röhrchen, die auf einem Isolierrohr sitzen und in axialen Flachabschnitten die Enden des Schmelzleiters klemmen.

Obschon in der Literatur zu SMT und SMD eine Reihe von Publikationen existiert, sei hier kurz in Erinnerung gerufen, dass SMT "surface mounting technik" oder "surface mounted technology", und SMD "surface mounted device", also Oberflächenmontagetechnik bzw. ein dafür geeignetes Teil, bedeuten. Bei der SMT werden die Anschlussbeinchen (auch "Pin" genannt) der SMD an ein Lötfeld (auch "Pad" genannt) nach dem Reflow-Lötverfahren oder nach dem Wellenlötverfahren angelötet.

Der Erfindung liegt die Aufgabe zugrunde, ein Sicherungselement zu schaffen, welches als SMD für SMT geeignet ist, wobei nebst kleinen Abmessungen, Eignung für beide Lötverfahren und hohe Betriebssicherheit auch Wirtschaftlichkeit im Vordergrund steht. Deshalb ist auch angestrebt, dass dieses Sicherungselement sich vollautomatisch fertigen lässt und auch zur automatischen Bestückung von Leiterplatten verwendbar sein soll.

Zur Lösung dieser Aufgabe wird das im Anspruch 1 definierte Sicherungselement vorgeschlagen.

Hinsichtlich des Oberbegriffs des Anspruch 1 ist dazu vorerst auszuführen, dass hinsichtlich der Verbindung eines Schmelzleiter-Endes mit einem Endkontakt im wesentlichen folgende Sicherungselemente bekannt sind, wobei das Gehäuse in der Regel ein Isolierrohr und die Endanschlüsse in der Regel Kappen sind, welche Kappen aussen auf dem Isolierrohr sitzen. Die nachfolgenden Ausführungen zum Stand der Technik sind hierauf abgestimmt:
- a) Das durch ein Loch der Kappe geführte Ende des Schmelzleiters ist mit der Kappe durch eine sogenannte Aussenlötstelle verbunden. Dabei muss das Löten mit ausreichender Wärmezufuhr erfolgen, um einen guten Kontakt sicherzustellen. Eine zu grosse Wärmemenge kann unerwünschte Veränderungen des Schmelzleiters (z.B. Legierung) nach sich ziehen. Da man die aggressiven Flussmittel, welche zum Löten von Schmelzleitern aus Widerstandsmaterial erforderlich sind, aus dem fertigen Geräte-Sicherungseinsatz nicht entfernen kann, besteht die Gefahr von Fehlergebnissen wegen Korrosion durch solche Flussmittelrückstände. Derartige Sicherungseinsätze mit Schmelzleitern aus Widerstandsmaterial sind daher zumindest als in der Herstellung problematisch zu bezeichnen. Auch der Rationalisierung sind deshalb Grenzen gesetzt, wobei das Löten in Handarbeit gemacht zu hohen Kosten führt.
- b) Das zwischen Isolierrohr und als Kappe ausgebildeten Endanschluss befindliche Ende des Schmelzeinsatzes ist im Inneren des Schmelzeinsatzes durch eine sogenannte Innenlötstelle mit dem Kappenboden verbunden. Auch beim Löten im Flachabschnitt gemäss GB-A-824 827 ist dies so. Die für eine gute Innenlötstelle erforderliche Wärmemenge ist schwer zu steuern, wenn man ein sicheres Schmelzen des im Kappeninneren angebrachten Zinnteiles wünscht, aber keine Ueberhitzung der Innenlötstelle herbeiführen darf, weil sonst unerwünschte Veränderungen (z.B. Legierung) auftreten können. Flussmittel kann sich isolierend um den Schmelzleiter legen und/oder korrosiv wirken, was besonders bei den vorstehend erwähnten aggressiven Flussmitteln für Schmelzleiter aus Widerstandsmaterial dazu Anlass gibt, solche Schmelzleiter praktisch auszuschliessen. Die unvermeidliche Berührung des Schmelzleiters mit dem Isolierrohr und die Schräglage des Schmelzleiters im Isolierrohr können zu unvorhersehbaren Streuungen Anlass geben. Der Lötvorgang ist zudem nicht problemlos.
- c) Das Ende des Schmelzleiters ist zwischen Kappe und Isolierrohr durch reine Klemmwirkung gehalten. Die mit Rücksicht auf die Isolierrohrfestigkeit erzielbaren Klemmkräfte können stark schwanken (z.B. wegen Toleranzen des Isolierrohrdurchmessers). Der Schmelzleiter kann durch Zugkräfte beim Aufpressen der Kappe überdehnt oder abgerissen werden. Auch hier ergibt das unvermeidliche Anliegen des Schmelzleiters am Isolierrohr weitere Unsicherheit.
- d) Nach der CH-PS 566 641, hatte man die vorgenannten Mängel dadurch zu vermeiden versucht, dass jedes Schmelzleiterende zwischen zwei angenähert diametral in der betreffenden Kappe angeordnete Lappen angenähert zentrisch zum Isolierrohr innerhalb des letzteren einklemmte. Dieser Geräte-Sicherungseinsatz erlaubte zwar eine relativ freie Wahl des Schmelzeinsatzes und vermied die Nachteile der vorgenannten drei Arten von Sicherungseinsätzen; in der Praxis zeigten sich aber Probleme, welche sich unerwartet einer rationellen Fertigung entgegenstellten; auch die Notwendigkeit, in einem gesonderten Arbeitsgang das zwangsläufig offene Kappenende verschliessen zu müssen, wenn man (wie üblich) eine Füllung des Geräte-Sicherungseinsatzes mit einem körnigen Lichbogenlöschmedium wünscht, wirkt sich ungünstig aus.

Den genannten bekannten Sicherungselementen fehlt sowohl die Eignung für SMT als auch für eine automatische Fertigung.

Durch die kennzeichnende Konstruktion des Sicherungselements ist es hingegen möglich, dieses für SMT einzusetzen und seine Herstellung vollständig zu automatisieren.

Das Gehäuse kann durch Kunststoffspritztechnik einfach und in üblicher Kunststoffpräzision automatisch gefertigt werden, wobei man gegebenenfalls die Röhrchen bereits einspritzen kann. Wenn man es vorzieht, die Röhrchen nicht einzuspritzen, weil dies mit einem gewissen Aufwand verbunden sein kann, kann man nur das Gehäuse herstellen und zur gegebenen Zeit einer Vorrichtung zum Zusammenbau des Sicherungselements zuführen.

An dieser Vorrichtung kann man dann in jedes Ende des Hohlraums je ein Röhrchen automatisch einsetzen, den Schmelzleiterdraht automatisch einziehen und die Röhrchen abplatten um den Schmelzleiter zu klemmen. Die dabei erhaltenen Flachabschnitte kann man dann automatisch zu den Lötbeinchen biegen.

Die so erhaltenen Sicherungselemente verpackt in Tapes, Blistern und Magazinen etc., lassen sich den Montagevorrichtungen zur Printherstellung zuführen, wo eine automatische Bestückung erfolgen kann.

Die Flachabschnitte sind vorzugsweise ausserhalb des Gehäuses angeordnet und weisen vorzugsweise einen in Richtung der Achse verlaufenden Teil auf, welcher dem Rohrabschnitt benachbart ist.

Durch entsprechende Halterung des Rohrabschnitts kann man vermeiden, dass sich beim Flachdrücken der Flachabschnitte eine unerwünschte Verformung der Rohrabschnitte ereignet. Solche unerwünschten Verformungen könnten sich nämlich nachteilig auf die Verbindung mit dem Gehäuse auswirken.

Die Rohrabschnitte und die Flachabschnitte schliessen den Hohlraum gegenüber einem lichtbogenlöschenden körnigen Material dicht ab. Also kann das Sicherungselement in einer bevorzugten Ausführungsform gegenüber einem darin befindlichen lichtbogenlöschenden körnigen Material (z.B. Quarzsand) dicht ausgebildet sein, ohne dass man besondere Massnahmen treffen müsste. Das Einfüllen des Lichtbogenlöschmaterials kann durch eine seitliche Oeffnung des Gehäuses in das mit Endanschlüssen und Schmelzleiter bereits versehene Gehäuse erfolgen, so dass kein derartiges Material in die Klemmstellen geraten kann. Danach kann man diese seitliche Oeffnung des Gehäuses schliessen.

Vorteilhaft steht der Flachabschnitt, insbesondere im Bereich der Klemmstelle, entlang einer gewissen, meist kleinen Strecke, axial vom Rohrabschnitt ab bevor er aus der Achse abgebogen verläuft. Man kann dann z.B. bis zu dieser Stelle den Endkontakt beim Biegen festhalten, so dass die Biegekräfte nicht auf den im Gehäuse steckenden Rohrabschnitt übertragen werden.

Die formale Ausbildung der Lötbeinchen aus den beiden Flachabschnitten ist praktisch unbegrenzt, es werden jedoch zwei praktisch bewährte Lötbeinchen-Formen vorgezogen, von denen die eine sozusagen Z-artig und die andere gewissermassen C-artig ist. Bei der C-artigen Form der Lötbeinchen kann man durch die Grösse der Biegungsradien ein mehr oder weniger ausgeprägtes Federverhalten und/oder eine gewisse Dilatationskompensation erzielen. Beide Lötbeinchen-Formen eignen sich für beide Lötverfahren.

Die erfindungsgemässe Herstellung eines erfindungsgemässen bzw, bevorzugten Sicherungselements ist im Anspruch 7 gekennzeichnet.

Man kann dazu in jedes der beiden Hohlraumenden je einen Rohrabschnitt je eines Röhrchens koaxial zur Achse einsetzen und dann wie oben beschrieben weiterfahren.

Die Erfindung wird nachstehend anhand der rein schematischen Zeichnung beispielsweise besprochen werden.

Es zeigen:
- Fig. 1: eine vergrösserte Draufsicht auf eine erste Ausführungsform eines Sicherungselements in SMD Bauweise,
- Fig. 2: eine Seitenansicht nach Pfeil II in Fig. 1,
- Fig. 3: eine Endansicht nach Pfeil III in Fig. 1,
- Fig. 4: einen Längsschnitt nach Linie IV-IV in Fig. 1, in welchem kein Lichtbogenloschmittel eingezeichnet ist, weil es die Uebersichtlichkeit stören würde,
- Fig. 5: ein der Fig. 4 ähnlicher Schnitt einer zweiten Ausführungsform eines Sicherungselements, welcher sich nur hinsichtlich der Form der Lötbeinchen von der ersten Ausführungsform unterscheidet.
- Fig. 6: eine teilweise gebrochene und teilweise geschnittene "Explosionszeichnung" des Gehäuses und der noch röhrchenförmigen Endkontakte vor dem Zusammenbau zu einem Sicherungselement der ersten Ausführungsform gemäss den Fig. 1 bis 4, und
- Fig. 7: eine teilweise gebrochene und teilweise geschnittene Darstellung des Sicherungselementes 1 der Fig. 1-4 vor dem Biegen der Flachabschnitte.

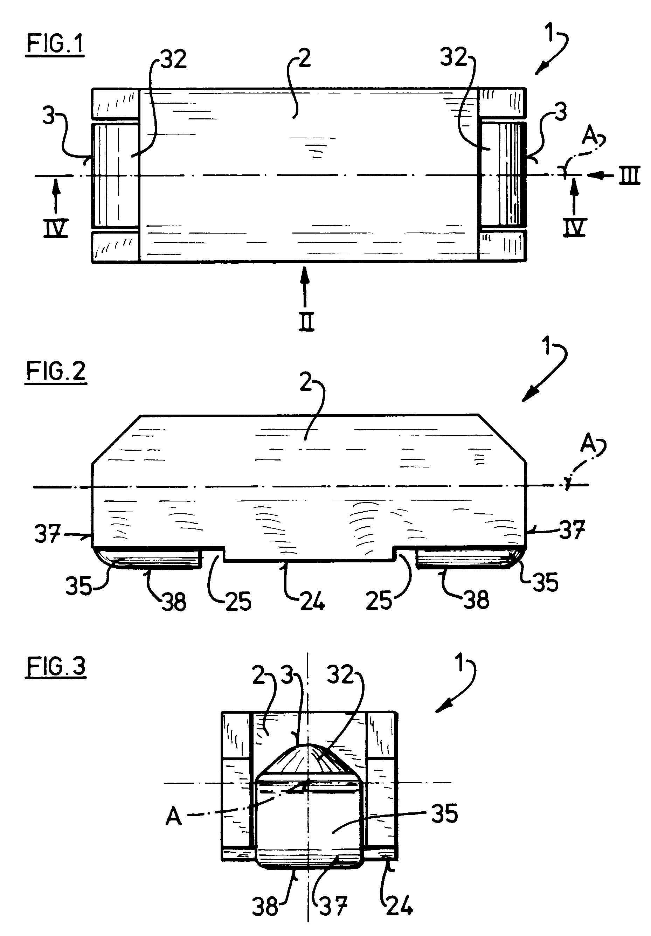

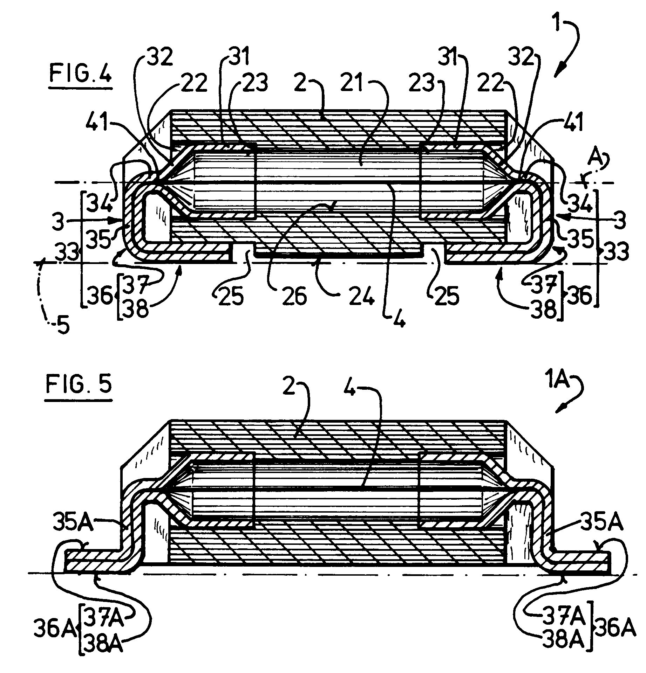

In den Fig. 1-4, 6 und 7 sind folgende Zeichen enthalten:
A Achse
   1 Sicherungselement, 1. Ausführungsform in SMD Bauweise
   2 Gehäuse
      21 Hohlraum von 2
      22 Hohlraumenden (zwei) von 21
      23 Absätze (zwei) von 22 gegenüber Mitte, in 21
      24 Unterseite von 2 (im Gebrauch dem Print zugewandt)
      25 Ausnehmungen (zwei) in 24
      26 Hohlraummittelbereich von 21
   3 Endkontakte (zwei)
      31 Rohrabschnitte (zwei), je einer in 22 als Teil von 3
      32 Uebergangsabschnitte (zwei) zwischen 31 und 33
      33 Flachabschnitte (zwei), je als Teil von 3
      34 Klemmstellen (zwei) je Teil von 33
      35 Lötbeinchen (zwei), je als Teil von 33
      36 Lötabschnitte (zwei), je als Teil von 35
      37 Wellenlötbereiche (zwei) je von 36
      38 Reflowlötbereiche (zwei) je von 36
   4 Schmelzleiter
      41 Schmelzleiterenden von 4, in 34 geklemmt
   5 Leiterplatte, durch strichpunktierte Linie angedeutet
In Fig. 5 sind mit den folgenden Ausnahmen die Teile mit den gleichen Zeichen bezeichnet:
1A Sicherungselement, 2. Ausführungsform in SMD-Bauweise
35A Lötbeinchen
36A Lötabschnitte
37A Wellenlötbereich
38A Reflowlötbereich
Die in Fig. 1 bis 4 dargestellte erste Ausführungsform des Sicherungselementes 1 weist ein sich entlang der Achse A erstreckendes Gehäuse 2 aus geeignetem isolierenden Material, wie zum Beispiel Kunststoff, Keramik und dergleichen auf.

Im Inneren des Gehäuses erstreckt sich entlang der Achse A ein durchgehender, an seinen beiden Ende offener Hohlraum 21, der mit einem körnigen lichtbogenlöschenden Material, z.B. Quarzsand, gefüllt sein kann. Diese Füllung wurde hier aus Gründen der Uebersichtlichkeit nicht dargestellt.

In jedem der beiden Hohlraumenden 22 steckt ein metallener Endkontakt 3.

Die beiden Endkontakte 3 sind durch einen auf der Achse A des Gehäuses 2 gelegenen Schmelzleiter 4 elektrisch leitend miteinander verbunden.

Jeder der beiden Endkontakte 3 sitzt mit seinem Rohrabschnitt 31 fest im betreffenden Hohlraumende 22. Die Befestigung kann auf an sich bekannte beliebige Weise erfolgen, beispielsweise durch Kleben, Klemmen, Umspritzen und dergleichen.

Der Rohrabschnitt 31 geht über den Uebergangsabschnitt 32 allmählich in den Flachabschnitt 33 über. Der Flachabschnitt besteht aus der Klemmestelle 34 und dem Lötbeinchen 35. Während sich die Klemmstelle 34 noch auf der Achse A befindet, ist das Lötbeinchen 35 aus der Achse A herausgebogen.

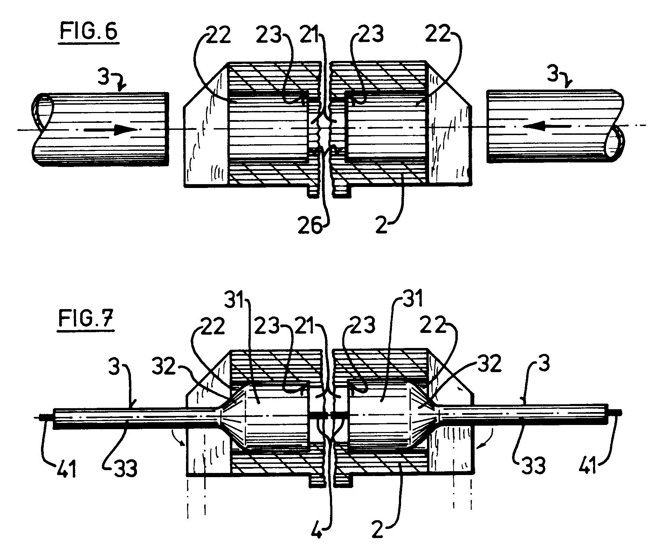

Jeder der beiden Endkontakte 3 steht bei der Herstellung (Fig. 6 und 7) in Richtung der Achse A ausserhalb des Hohlraumes 21 ab, und ist einem Greiforgan (nicht dargestellt) zum Quetschen gut zugänglich.

Jede der beiden Klemmstellen 34 ist in Fig. 4 im gequetschten Zustand dargestellt, in welchem sie ein Schmelzleiterende 41 des Schmelzleiters 4 sowohl mechanisch haltert, als auch die Endkontakte 3 miteinander durch den Schmelzleiter 4 elektrisch leitend verbindet.

Die Rohrabschnitte 31 schliessen bündig an den Absätzen 23 an, so dass sie mit ihrer Innenseite fluchtend zum Hohlraummittelbereich 26 verlaufen, was das Einziehen des Schmelzleiters 4 im Zuge der Herstellung sehr erleichtert.

Der Flachabschnitt 33 ist anschliessend an die Klemmstelle 34 zu einem Lötbeinchen 34 ausgeformt.

Das Lötbeinchen 34 ist erst rechtwinklig aus der Achse A in Richtung zur Unterseite 24 des Gehäuses 2, zum Wellenlötbereich 37 herausgebogen, um dann parallel zur Achse A in einer Ausnehmung 25 der Unterseite 23 des Gehäuses 2 den Reflowlötbereich 38 zu bilden, wobei die beiden Bereiche 37 und 38 zusammen einen Lötabschnitt 36 des Lötbeinchens 35 bilden.

Durch die Ausnehmungen 25 wird sichergestellt, dass die Reflowlötbereiche 38 zwar im Gehäuse 2 geschützt sind, aber soweit gegenüber der Unterseite 24 vorstehen, dass sie zu einer mit strichpunktierung angedeuteten Leiterplatte 5 einen gewissen Abstand aufweisen, welcher einem Klebemittel Platz bieten kann.

Gegenüber dieser ersten Ausführungsform unterscheidet sich die zweite Ausführungsform des Sicherungselementes 1A gemäss Fig. 5 nur durch eine andere Konfiguration der Lötbeinchen 35A, deren Lötabschnitt 36A jeweils vom Gehäuse 2 hinweg gebogen sind und dort den Wellenlötbereich 37A und den Reflowlötbereich 38A bildet. Darum sind in Fig. 5 auch nur die soeben genannten Ueberweisungszeichen angegeben worden.

In den Fig. 6 und 7 ist sehr grob die Herstellung der ersten Ausführungsform des Sicherungselements 1 dargestellt.

Das Gehäuse 2 erstreckt sich entlang der Achse A, zu welchem der Hohlraum koaxial verläuft. Man schiebt unter entsprechendem Klemmsitz die noch als Röhrchen ausgebildeten Endkontakte 3 entlang der Achse bis an die Absätze 23 der Hohlraumenden 22 ein, zieht dann den Schmelzleiter 4 ein und klemmt seine Enden 41 in den Klemmstellen 34 der Flachabschnitte, die man durch Abplatten der Röhrchen erhält. Durch Biegen der Flachabschnitte 33 erzeugt man die Lötbeinchen 35 und gelangt so zum Sicherungselement 1 der Fig. 1 bis 4. Durch etwas anderes Abbiegen würde man zum Sicherungselement 1A gelangen können.

## Patentansprüche

1. Sicherungselement (1; 1A)
- mit einem elektrisch isolierenden Gehäuse (2), in welchem ein an beiden Enden (22) offener und sich entlang einer Achse (A) durchgehend erstreckender Hohlraum (21) ausgebildet ist, und
- mit zwei jeweils einen Rohrabschnitt (31) und einen Flachabschnitt (33) aufweisenden einteiligen und elektrisch leitenden Endkontakten (3), deren jeder über seinen Rohrabschnitt (31) mit einem Hohlraumende (22) des Gehäuses (2) verbunden ist, sowie
- mit einem Schmelzleiter (4), welcher im Hohlraum (21) angenähert konzentrisch zur Achse (A) verläuft und an jedem seiner beiden Enden (41) mittels der als Klemmstelle (34) und Lötbeinchen (35; 35A) dienenden Flachabschnitte (33) der Endkontakte (3) am letzteren elektrisch leitend befestigt ist, dadurch gekennzeichnet, dass
jeder der beiden Endkontakte (3) je mit seinem Rohrabschnitt (31) in das Innere des zugehörigen Hohlraumendes (22) greift, während jeder der beiden Flachabschnitte nach seinem Herausbiegen zur gleichen Seite hin von der Achse (A) zu einem zur Achse (A) angenähert parallelen Lötabschnitt (36) des betreffenden Lötbeinchens (35) geformt ist, welche Lötabschnitte gegenüber der Unterseite (24) des Sicherungslementes quer zur Achse vorspringen.

2. Sicherungslement nach Anspruch 1, dadurch gekennzeichnet, dass jeder der beiden Flachabschnitte (33) vom zugehörigen Rohrabschnitt (31) vorerst ein Stück weit in Richtung der Achse (A) nach aussen absteht.

3. Sicherungselement nach Anspruch 1 oder 2, dadurch gekennzeichnet, dass der Lötabschnitt (36) an einer Unterseite (24) des Gehäuses (2), vorzugsweise in einer Ausnehmung (25), angeordnet ist.

4. Sicherungselement nach Anspruch 1 oder 2, dadurch gekennzeichnet, dass der Lötabschnitt (36A) vom Gehäuse (2) hinweggerichtet ist.

5. Sicherungselement nach einem der Ansprüche 1 bis 4, dadurch gekennzeichnet, dass jedes der beiden Hohlraumenden (22) gegenüber einem Hohlraummittelbereich (26) um so viel erweitert ist, dass jeder der darin steckenden Rohrabschnitte (31) innen mit dem Hohlraummittelbereich (26) fluchtet.

6. Sicherungselement nach einem der Ansprüche 1 bis 5, dadurch gekennzeichnet, dass es gegenüber einem darin enthaltenen lichtbogenlöschenden körnigen Material, z.B. Quarzsand, dicht abgeschlossen ist.

7. Verfahren zum Herstellen eines Sicherungselementes nach einem der Ansprüche 1 bis 6, dadurch gekennzeichnet, dass man ein Gehäuse (2) mit zwei Endkontakten (3), welche noch ganz röhrchenförmig sind und je mit ihrem späteren Rohrabschnitt (31) in einem der beiden Hohlraumenden (22) koaxial zur Achse (A) stecken, herstellt, einen Scnmelzleiter (4) in den Hohlraum (21) und in die noch ganz röhrchenförmigen Endkontakte (3) einzieht und durch Flachdrücken eines Teils der noch röhrchenförmigen Endkontakte (3) die beiden Falchabschnitte (33) bildet, wobei je eines der Schmelzleiterenden (41) in einer dabei gebildeten Klemmstelle (34) geklemmt wird, und dass man wenigstens einen Teil des Flachabschnitts (33) jedes Endkontakts (3) aus der Achse (A) herausbiegt und zu einem zur Achse (A) angenähert parallelen Lötabschnitt (36) formt, welcher gegenüber der Unterseite (24) des Gehäuses quer zur Achse (A) vorspringt.

## Claims

1. A fuse element (1;1A)
- with an electrically insulating casing (2), in which is formed a cavity (21) which is open at both ends and which extends right along an axis (A),
- with two one-piece, electrically conductive end contacts (3), each having a tubular section (31) and a flat section (33) and each being connected by its tubular section (31) to one end (22) of the cavity in the casing (2), and
- with a fusible conductor (4) extending through the cavity (21) approximately concentrically with the axis (A) and, at each of its two ends (41), being attached electrically conductively, by means of the flat sections (33) of the end contacts (3), to the latter, which act as a clamping point (34) and soldering pin (35;35A), characterised in that
the tubular section (31) of each of the two end contacts (3) engages inside the associated end (22) of the cavity, while each of the two flat sections, after being bent out in the same direction from the axis (A), is shaped into a soldering section (36) of the relevant pin (35) approximately parallel with the axis (A), the soldering sections projecting from the underside (24) of the fuse element transversely to the axis.

2. A fuse element according to claim 1, characterised in that each of the two flat sections (33) initially projects outwardly from the associated tubular section (31), some distance in the direction of the axis (A).

3. A fuse element according to claim 1 or 2, characterised in that the soldering section (36) is located at an underside (24) of the casing (2), preferably in a recess (25).

4. A fuse element according to claim 1 or 2, characterised in that the soldering section (36A) is directed away from the casing (2).

5. A fuse element according to any of claims 1 to 4, characterised in that each of the two ends (22) of the cavity is wider than a central portion (26) of the cavity by an amount such that each of the tubular sections (31) fitted therein is internally aligned with the central portion (26) of the cavity.

6. A fuse element according to any of claims 1 to 5, characterised in that it is tightly sealed off from an arc-extinguishing granular material contained therein, e.g. silica sand.

7. A method of making a fuse element according to any of claims 1 to 6, characterised in that a casing (2) is made, with two end contacts (3) which are still completely tubular and each of which has its eventual tubular section (31) fitted into one of the two ends (22) of the cavity coaxially with the axis (A), that a fusible conductor (4) is drawn into the cavity (21) and into the still completely tubular end contacts (3), and the two flat sections (33) are formed by flattening part of the still tubular end contacts (3), one end (41) of the fusible conductor in each case being clamped at a clamping point (34) formed in the process, and that at least part of the flat section (33) of each end contact (3) is bent out of the axis (A) and shaped as a soldering section (36) which is approximately parallel with the axis (A) and which projects from the underside (24) of the casing transversely to the axis (A).

## Revendications

1. Cartouche fusible (1, 1A)
- avec un boîtier (2) électriquement isolant, dans lequel est formé un espace creux (21) ouvert à ses deux extrémités (22) et s'étendant le long d'un axe (A) d'un bout à l'autre et
- avec deux contacts terminaux (3) monoblocs présentant une section tubulaire (31) et une section plate (33) et conduisant l'électricité, dont chacun est relié par sa section tubulaire (31) à l'une des extrémités (22) de l'espace creux du boîtier (2), ainsi qu'
- avec un conducteur fusible (4), qui s'étend dans l'espace creux (21) de façon approximativement concentrique à l'axe (A) et est fixé à chacune de ses extrémités (41) au moyen des sections plates (33) des contacts terminaux (3) servant de points de serrage (34) et de jambettes de brasage (35, 35A) sur le contact de façon à conduire l'électricité,
cartouche fusible caractérisée en ce que chacun des deux contacts terminaux (3) vient en prise par sa section tubulaire (31) à l'intérieur de l'extrémité correspondante (22) de l'espace creux, tandis que chacune des deux sections plates est formée après avoir été coudée vers le même côté de l'axe (A) pour constituer une section de brasage (36) à peu près parallèle à l'axe (A) de la jambette de brasage correspondante (35), lesquelles sections de brasage font saillie par rapport au côté inférieur (24) de la cartouche fusible perpendiculairement à l'axe.

2. Cartouche fusible selon la revendication 1, caractérisée en ce que chacune des deux sections plates (33) s'écarte de la section tubulaire correspondante (31) d'abord un petit peu dans le sens de l'axe (A) vers l'extérieur.

3. Cartouche fusible selon la revendication 1 ou 2, caractérisée en ce que la section de brasage (36) est disposée sur un côté inférieur (24) du boîtier (2), de préférence dans un évidement (25).

4. Cartouche fusible selon la revendication 1 ou 2, caractérisée en ce que la section de brasage (36A) est orientée de façon à s'écarter du boîtier (2).

5. Cartouche fusible selon l'une des revendications 1 à 4, caractérisée en ce que chacune des deux extrémités (22) de l'espace creux est élargie par rapport à une zone médiane de l'espace creux suffisamment pour que chacune des sections tubulaires (31) s'enfonçant dedans coïncide à l'intérieur avec la zone médiane de l'espace creux (26).

6. Cartouche fusible selon l'une des revendications 1 à 5, caractérisée en ce qu'elle est fermée de façon étanche par rapport a une matière granuleuse, contenue dedans, servant à éteindre l'arc électrique, par exemple du sable siliceux.

7. Procédé pour fabriquer une cartouche fusible selon l'une des revendications 1 à 6, caractérisé en ce que l'on fabrique un boîtier (2) avec deux contacts terminaux (3), qui ont encore la forme de petits tubes et s'enfoncent chacun par leur section tubulaire ultérieure (31) dans l'une des deux extrémités de l'espace creux (22) de façon coaxiale à l'axe (A), que l'on enfile un conducteur fusible (4) dans l'espace creux (21) et dans les contacts terminaux (3) ayant encore tout à fait la forme de petits tubes et que l'on forme en aplatissant une partie des contacts terminaux (3) ayant encore la forme de petits tubes les deux sections plates (33), l'une des extrémités (41) du conducteur fusible étant serrée dans un point de serrage (34) formé à cet endroit et en ce que l'on coude à partir de là, au moins une partie de la section plate (33) de chaque contact terminal (3) à partir de l'axe (A) et que l'on forme une section de brasage (36) à peu près parallèle à l'axe (A), section qui fait saillie par rapport au côté inférieur (24) du boîtier perpendiculairement à l'axe (A).
